# FASCICULE DE BREVET EUROPEEN

(11) **EP 0 586 010 B1**
(45) Date de publication et mention de la délivrance du brevet: **11.12.1996**
(21) Numéro de dépôt: 93202495.3
(22) Date de dépôt: 25.08.1993
(51) Int. Cl.: H05K 7/14, H05K 9/00

(54) **Circuit pour des fréquences élevées, et procédé pour le réaliser**
Hochfrequenzschaltung und Verfahren zur deren Herstellung
High frequency circuit device and method for making the same

(30) Priorité: 02.09.1992 FR 9210480
(43) Date de publication de la demande: 09.03.1994
(73) Titulaire: PHILIPS ELECTRONIQUE GRAND PUBLIC, 92150 Suresnes (FR); Philips Electronics N.V., 5621 BA Eindhoven (NL)
(72) Inventeur: Chanteau, Pierre, F-75008 Paris (FR)
(74) Mandataire: Caron, Jean

(56) Documents cités:
- EP-A- 0 222 445
- EP-A- 0 332 909
- EP-A- 0 391 327
- DE-U- 8 911 412
- GB-A- 2 219 892

## Description

La présente invention concerne un dispositif électronique pour des fréquences jusqu'à deux gigaherz comportant un boîtier contenant un circuit imprimé avec éventuellement des composants actifs et/ou passifs rapportés, circuit imprimé muni de pistes métallisées constituant des lignes électriques qui sont montées parallèlement à une plaque électriquement conductrice servant de plan de masse.

Elle concerne aussi un procédé pour réaliser un tel dispositif.

Un tel dispositif s'applique notamment à des circuits destinés à la distribution de télévision par câble, dans lesquels les signaux ont des fréquences, y compris celles correspondant à des signaux de télévision par satellite en bande intermédiaire, qui vont de 40 à 2050 Mhz.

Un dispositif présentant des lignes électriques montées parallèlement à une plaque électriquement conductrice est connu par le document EP-A-0 222 445. Le plan de masse selon ce document est constitué, comme cela est habituel, par une métallisation de la face arrière du circuit imprimé. Avec un tel dispositif, le champ électrique de la ligne se développe principalement dans le matériau du circuit imprimé, ce qui provoque en haute fréquence des pertes et des désadaptations excessives dûes aux mauvaises qualités et à l'irrégularité de ce matériau, à moins d'utiliser un matériau de très haute qualité qui serait coûteux.

L'invention se propose de fournir un dispositif qui ait de bonnes performances du point de vue des pertes et de l'adaptation d'impédance, en employant des matériaux standard et des éléments mécaniques courants.

Elle est basée sur l'idée de mettre en série le diélectrique du matériau du circuit imprimé (à constante diélectrique et indice de pertes élevés) avec une lame d'air mince (à indice de pertes quasi nul) de telle façon que l'incidence de cette dernière soit importante, mais que néanmoins la capacité entre les lignes et la masse soit suffisamment forte pour que l'impédance caractéristique des lignes puisse être respectée sans devoir exagérément élargir les lignes.

Ainsi un dispositif selon l'invention est remarquable en ce que, les dits composants étant du type à montage en surface et le circuit imprimé étant du type simple face avec les métallisations sur une face dite avant alors que l'autre face dite arrière n'est pas métallisée, la face arrière du circuit imprimé est accolée à la plaque électriquement conductrice, cette dernière est une paroi plane du boîtier, cependant que des moyens sont prévus pour maintenir un espacement entre la face arrière et la paroi.

Un autre avantage du dispositif selon l'invention par rapport à un dispositif comportant une métallisation de masse au dos du circuit imprimé est que le circuit simple face est meilleur marché que le circuit double face.

Un avantage subsidiaire est que pour une même épaisseur du substrat de circuit imprimé, les inductances imprimées sur le circuit ont, à valeur de self-inductance égale, une fréquence d'auto-résonance plus élevée et un meilleur coefficient de surtension.

Avantageusement, le boîtier ayant la formé d'un parallélépipède assez plat, c'est-à-dire dont deux faces opposées sont plus grandes que les autres, la dite paroi plane est située à l'intérieur du boîtier, en position sensiblement médiane entre les deux plus grandes faces.

Lorsqu'on utilise un circuit imprimé standard ayant pratiquement une épaisseur de 16/10^{e} de millimètre, le dit espacement est avantageusement compris entre 0,2 et 0,6 millimètre.

Cette valeur de l'espacement procure un bon compromis entre toutes les exigences plus ou moins contradictoires qui s'imposent : si l'espacement est trop mince, le matériau du circuit imprimé prédomine et les performances diélectriques sont mauvaises, et en outre les dispersions sur la valeur de l'espacement sont plus grandes, et si l'espacement est grand, les lignes doivent être plus larges et la dimension générale du circuit trop grande.

Pour maintenir un espacement entre la dite face arrière et la dite paroi, cette dernière est avantageusement munie de pions, constitués d'une embase sur laquelle est appuyé le circuit imprimé, et d'une tige dont la section est inférieure à celle de l'embase et qui pénètre dans un trou du circuit imprimé.

Ainsi la réalisation mécanique est assurée de manière simple et peu coûteuse.

Le circuit imprimé est muni de plages métallisées autour des trous destinés au passage des pions, ce qui permet une fixation simple du circuit imprimé sur la paroi du boitier, en soudant le circuit aux pions, et au moins certaines de ces plages métallisées sont reliées à des points du circuit électrique, constitué par les pistes métallisées du circuit imprimé, qui doivent être reliés à la masse. Ainsi la fixation du circuit par soudure permet de réaliser par la même occasion des mises à la masse électriques.

Un procédé avantageux pour réaliser un dispositif électronique dans lequel le circuit imprimé est fixé aux pions par soudure et supporte des composants du type à montage en surface est remarquable par la séquence d'opérations suivante :
- on enduit le circuit imprimé de pâte à souder aux emplacements ad-hoc pour le montage des composants et aussi autour des trous prévus pour le passage des pions,
- on met en place les composants sur les emplacements enduits de pâte,
- on met en place le circuit imprimé dans le boitier,
- et enfin on soude en une seule opération les composants sur le circuit imprimé et le circuit imprimé sur les pions.

Ces aspects de l'invention ainsi que d'autres aspects plus détaillés apparaîtront plus clairement grâce à la description suivante d'un mode de réalisation non limitatif.

La figure 1 est une vue en coupe d'un boitier contenant un dispositif selon l'invention.

La figure 2 est une vue en coupe et à plus grande échelle d'un pion de fixation du circuit imprimé dans le boîtier.

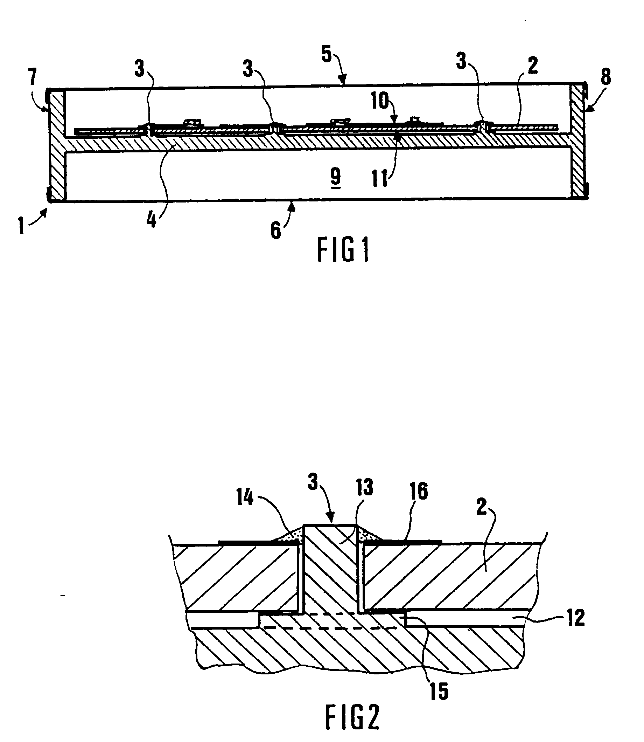

Le dispositif électronique représenté sur la figure 1 comprend un boîtier 1 ayant la forme d'un parallélipipède relativement plat. Deux faces opposées, celles que l'on peut nommer "dessus" et "dessous" qui sont perpendiculaires à la surface du dessin et dont les profils 5 et 6 sont indiqués, sont plus grandes que les autres, à savoir que les "petits côtés" 7, 8, et que les "grands côtés" dont on ne voit qu'un référencé 9. Une paroi plane 4 ou "plancher" (perpendiculaire à la surface du dessin) est située à l'intérieur du boîtier, en position sensiblement médiane entre les deux plus grandes faces 5 et 6. Ce boîtier est par exemple moulé en alliage d'aluminium et de zinc connu sous le nom de "ZAMAC", et étamé électrolytiquement. Les faces 5 et 6 sont en tôle étamée.

Sur le plancher 4 est disposé un circuit imprimé 2 en papier phénolique (par exemple correspondant au type PF-CPO2 selon la norme DIN 40802), dont l'épaisseur est par exemple de 16/10^{e} de millimètre. C'est un circuit imprimé simple face, c'est-à-dire avec des métallisations sur une face 10 dite avant alors que l'autre face 11 dite arrière n'est pas métallisée. Ce circuit imprimé est fixé sur des pions 3 qui viennent de moulage avec le plancher 4, et sont étamés electrolytiquement avec lui. Ces pions maintiennent un espacement entre la face arrière du circuit imprimé et la paroi 4.

La figure 2 représente un de ces pions. Ils est constitué d'une embase 15 sur laquelle est appuyé le circuit imprimé, et d'une tige 13 moins large que l'embase et qui pénètre au travers du circuit imprimé. La tige 13 permet le maintien du circuit imprimé et l'embase 15 impose un espacement 12. L'embase 15 a de préférence une épaisseur de 0,4 mm, procurant ainsi un espacement 12 de 0,4 mm. Cet espacement peut bien entendu prendre d'autres valeurs, mais il restera avantageusement compris entre 0,2 et 0,6 mm. Le diamètre des pions est par exemple de 1,3 mm. Il convient de prévoir des pions assez rapprochés pour éviter que le circuit imprimé puisse fléchir entre deux pions, ce qui fausserait la valeur de l'espacement. De toute façon ceci ne pose pas de problème car le nombre de points du circuit à relier à la masse est en général relativement grand, ce qui entraine la présence d'un grand nombre de pions.

Pour sa fixation dans le boitier, le circuit imprimé 2 est muni de plages métallisées annulaires 16 autour des trous destinés au passage des pions, et est soudé aux pions à ces endroits au moyen d'un congé de soudure 14. Au moins certaines de ces plages annulaires sont reliées à des points du circuit électrique, constitué notamment par des pistes métallisées du circuit imprimé, qui doivent être reliés à la masse.

Le soudage en question pourrait être fait au moyen d'un robot de soudage, qui agirait en reprise après le montage dans le boîtier d'un circuit terminé, c'est-à-dire avec tous ses composants éventuels déja montés. Néanmoins dans le cas où le circuit imprimé supporte des composants à montage en surface un procédé avantageux, parce qu'il réduit le nombre d'opérations, pour réaliser un dispositif électronique selon la description ci-dessus, consiste à :
- enduire d'abord le circuit imprimé de pâte à souder, par exemple par sérigraphie déposant sélectivement de la pâte aux emplacements ad-hoc pour le montage des composants, c'est-à-dire aux emplacements où l'on va placer les parties métallisées à souder des composants, et
- dans la même opération de sérigraphie, déposer aussi de la pâte autour des trous prévus pour le passage des pions, sur la plage annulaire métallisée prévue à cet endroit sur le circuit imprimé,
- puis monter les composants sur les emplacements enduits de pâte,
- mettre en place le circuit imprimé dans le boîtier,
- et enfin souder en une seule opération les composants sur le circuit imprimé et le circuit imprimé sur les pions, par exemple par soudage en phase vapeur, ou par chauffage dans un four.

La comparaison des performances d'un circuit tel que décrit ci-dessus, avec celles d'un circuit similaire mais utilisant un circuit imprimé directement appliqué sur la paroi 4, en tenant compte des dispersions de fabrication sur toutes les dimensions (épaisseur du circuit imprimé, de la lame d'air, largeur des pistes conductrices), ainsi que sur la constante diélectrique et l'indice de pertes du matériau du circuit imprimé, montre que le bénéfice est important : dans un cas particulier pris à titre d'exemple, on a trouvé qu'à deux Ghz, les pertes sont trois fois plus faibles que pour une ligne de même impédance réalisée sur un circuit imprimé directement appliqué sur la paroi. Les dispersions sur la valeur de l'impédance caractéristique de lignes fines (impédance caractéristique 135 Ω) servant à réaliser des inductances ont été trouvées égales à 4,4 %, contre 8,2 % pour un circuit imprimé directement appliqué sur la paroi. Le gain dû à l'invention, en se plaçant du point de vue des dispersions, est d'autant plus important que l'impédance de la ligne imprimée est élevée. Ceci est particulièrement avantageux lorsqu'il s'agit de réaliser des filtres sans réglage au moyen d'inductances imprimées, dont la valeur de self-inductance dépend de l'impédance caractéristique.

## Revendications

1. Dispositif électronique pour des fréquences jusqu'à deux gigaherz comportant un boîtier (1) contenant un circuit imprimé (2) avec éventuellement des composants actifs et/ou passifs rapportés, circuit imprimé muni de pistes métallisées constituant des lignes électriques qui sont montées parallèlement à une plaque électriquement conductrice servant de plan de masse, caractérisé en ce que, les dits composants étant du type à montage en surface et le circuit imprimé (2) étant du type simple face avec les métallisations sur une face dite avant (10) alors que l'autre face dite arrière (11) n'est pas métallisée, la face arrière (11) du circuit imprimé est accolée à la plaque électriquement conductrice, cette dernière est une paroi plane (4) du boîtier, cependant que des moyens sont prévus pour maintenir un espacement (12) entre la face arrière et la paroi.

2. Dispositif électronique selon la revendication 1, caractérisé en ce que, le boîtier ayant la forme d'un parallélipipède dont deux faces opposées (5, 6) sont plus grandes que les autres, la dite paroi plane (4) est située à l'intérieur du boîtier, en position sensiblement médiane entre les deux plus grandes faces (5, 6).

3. Dispositif électronique selon l'une des revendications 1 ou 2, caractérisé en ce que, le circuit imprimé (2) ayant pratiquement une épaisseur de 16/10^{e} de millimètre, le dit espacement (12) est compris entre 0,2 et 0,6 millimètre.

4. Dispositif électronique selon l'une quelconque des revendications précédentes, caractérisé en ce que, pour maintenir un espacement (12) entre la dite face arrière et la dite paroi, cette dernière est munie de pions (3), constitués d'une embase (15) sur laquelle est appuyé le circuit imprimé, et d'une tige (13) dont la section est inférieure à celle de l'embase et qui pénètre dans un trou du circuit imprimé.

5. Dispositif électronique selon la revendication précédente, caractérisé en ce que le circuit imprimé (2) est muni de plages métallisées (16) autour des trous destinés au passage des pions, et est soudé aux pions.

6. Dispositif électronique selon la revendication précédente, caractérisé en ce qu'au moins certaines des dites plages métallisées (16) sont reliées à des points du circuit électrique, constitué par les pistes métallisées du circuit imprimé, qui doivent être reliés à la masse.

7. Procédé pour réaliser un dispositif électronique selon l'une des revendications 5 ou 6, dans lequel le circuit imprimé supporte des composants du type à montage en surface, caractérisé par la séquence d'opérations suivante :
- on enduit le circuit imprimé de pâte à souder aux emplacements ad-hoc pour le montage des composants et aussi autour des trous prévus pour le passage des pions,
- on met en place les composants sur les emplacements enduits de pâte,
- on met en place le circuit imprimé dans le boîtier,
- et enfin on soude en une seule opération les composants sur le circuit imprimé et le circuit imprimé sur les pions.

## Patentansprüche

1. Elektronische Vorrichtung für Frequenzen bis zu zwei Gigahertz, bestehend aus einem Gehäuse (1) mit einer gedruckten Schaltung (2) und eventuell aktiven und/oder passiven Bauteilen, die gedruckte Schaltung ist mit metallisierten, elektrische Leitungen bildenden Spuren versehen, die parallel auf einer als Massefläche dienenden elektrischen Leiterplatte angebracht sind, mit dem Merkmal, daß die besagten Bauteile auf der Oberfläche zu montierenden Typs sind und die gedruckte Schaltung (2) einseitigen Typs ist, mit Metallisierungen auf der sogenannten Vorderseite (10), während die andere, sogenannte Rückseite (11) nicht metallisiert ist, die Rückseite (11) der gedruckten Schaltung liegt an die elektrische Leiterplatte an, die eine flache Wand (4) des Gehäuses bildet, und es sind Mittel vorgesehen, um zwischen der Rückseite und der Wand einen Abstand (12) zu halten.

2. Eine Vorrichtung laut Anspruch 1, mit dem Merkmal, daß das Gehäuse die Form eines Parallelipeds hat, bei dem zwei gegenüberliegende Seiten (5, 6) größer als die anderen sind, die besagte flache Wand (4) befindet sich im Innern des Gehäuses, nahezu in Mittelposition zwischen den beiden größeren Seiten (5, 6).

3. Eine Vorrichtung laut einem der Ansprüche 1 oder 2, mit dem Merkmal, daß die gedruckte Schaltung (2) praktisch eine Dicke von 16/10 Millimetern aufweist und der besagte Abstand (12) 0,2 bis 0,6 Millimeter beträgt.

4. Eine Vorrichtung laut einem der vorhergehenden Ansprüche, mit dem Merkmal, daß für den Erhalt eines Abstands (12) zwischen der besagten Rückseite und der besagten Wand diese mit sockelförmigen (15) Abstandshaltern (3) versehen wird, gegen die die gedruckte Schaltung gebracht wird, und mit Stiften (13), die einen kleineren Durchmesser als die Abstandshalter haben und in Locher in die gedruckte Schaltung eingeführt werden.

5. Eine Vorrichtung laut einem der vorhergehenden Ansprüche, mit dem Merkmal, daß die gedruckte Schaltung (2) um die für die Einführung der Stifte vorgesehenen Löcher mit metallisierten Bereichen (16) versehen ist und auf die Abstandshalter gelötet wird.

6. Eine Vorrichtung laut einem der vorhergehenden Ansprüche, mit dem Merkmal, daß mindestens einige dieser metallisierten Bereiche (16) über metallisierte Spuren der gedruckten Schaltung mit Punkten der elektrischen Schaltung verbunden sind, die mit der Masse verbunden werden müssen.

7. Ein Verfahren zur Herstellung einer elektronischen Vorrichtung laut einem der Ansprüche 5 oder 6 mit einer gedruckte Schaltung für Bauteile auf der Oberfläche zu montierenden Typs, das aus folgenden Verarbeitungsschritten besteht:
- Auf die gedruckte Schaltung wird an den entsprechenden, für die Montage der Bauteile vorgesehenen Stellen und um die für das Einführen der Abstandshalter vorgesehenen Löchern Lötfett aufgetragen,
- die Bauteile werden an den mit Fett eingeschmierten Stellen angebracht,
- die gedruckte Schaltung wird in das Gehäuse gebracht,
- und zuletzt werden in einem einzigen Vorgang die Bauteile auf die gedruckte Schaltung und die gedruckte Schaltung auf die Abstandshalter gelötet.

## Claims

1. An electronic device for frequencies of up to two gigahertz comprising a housing (1) containing a printed circuit (2), possibly with connected active and/or passive components, which printed circuit is provided with metallized tracks forming electric connecting lines which are mounted parallel to an electrically conducting plate which serves as a ground plan, characterized in that, the said components being of the surface mounted type and the printed circuit (2) being of the single-sided type with the metallizations on one surface, the so-called front surface (10), while the other or rear surface (11) is not metallized, the rear surface (11) of the printed circuit is coupled to the electrically conducting plate, and the latter is a plane wall (4) of the housing, while means are provided for maintaining a spacing (12) between the rear surface and the said wall.

2. An electronic device as claimed in Claim 1, characterized in that, the housing having the shape of a parallelepiped of which two opposed surfaces (5, 6) are greater than the others, the said plane wall (4) is situated in the interior of the housing in a substantially central position between the two largest surfaces (5, 6).

3. An electronic device as claimed in Claim 1 or 2, characterized in that, the printed circuit (2) having a thickness of practically 1.6 mm, the said spacing (12) lies between 0.2 and 0.6 mm.

4. An electronic device as claimed in any one of the preceding Claims, characterized in that to maintain a spacing (12) between the said rear surface and the said wall, the latter is provided with spacer blocks (3) formed by a base (15) against which the printed circuit is applied and a pin (13) whose cross-section is smaller than that of the base and which is passed through a hole in the printed circuit.

5. An electronic device as claimed in the preceding Claim, characterized in that the printed circuit (2) is provided with metallized pads (16) around the holes provided for the passage of the spacer blocks and is soldered to these blocks.

6. An electronic device as claimed in the preceding Claim, characterized in that at least some of the said metallized pads (16) are connected to points of the electric circuit, formed by the metallized tracks of the printed circuit, which are to be connected to earth.

7. A process for realising an electronic device as claimed in Claim 5 or 6, in which the printed circuit supports components of the surface mounted type, characterized by the following sequence of operations:
- the printed circuit is provided with soldering paste at locations where components are to be mounted and also around holes provided for the passage of the spacer blocks,
- the components are positioned on the pads provided with the paste,
- the printed circuit is positioned in the housing,
- finally, the components are soldered to the printed circuit and the printed circuit is soldered to the spacer blocks in a single operation.
